Europäisches Patentamt

European Patent Office

Office européen des brevets

(11) Veröffentlichungsnummer: **0 332 822**
**A1**

## EUROPÄISCHE PATENTANMELDUNG

(21) Anmeldenummer: **89101494.6**

(22) Anmeldetag: **28.01.89**

(51) Int. Cl.⁴: **H01L 29/72 , H01L 29/54 , H01L 29/62 , H01L 21/285 , H01L 21/60**

(30) Priorität: **22.02.88 CH 651/88**

(43) Veröffentlichungstag der Anmeldung:
**20.09.89 Patentblatt 89/38**

(84) Benannte Vertragsstaaten:
**CH DE FR GB IT LI NL SE**

(71) Anmelder: **ASEA BROWN BOVERI AG**
**Haselstrasse**
**CH-5401 Baden(CH)**

(72) Erfinder: **Bauer, Friedhelm, Dr.**
**Breitenstrasse 9**
**CH-5303 Würenlingen(CH)**

(54) **Feldeffektgesteuertes, bipolares Leistungshalbleiter-Bauelement sowie Verfahren zu seiner Herstellung.**

(57) Bei einem IGT (Insulated Gate Transistor) wird der Kurzschluss zwischen den n-Bereichen (5c) und den p-Bereichen (4b) der n-Emitterschicht bzw. p-Basisschicht durch eine vergrabene Leitschicht (12), speziell in Form einer Metallsilizidschicht, bewirkt.

Die Länge der n-Bereiche (5c) lässt sich dadurch unabhängig vom Abstand zwischen Kathodenkontakt (8) und Gate (7) soweit verkleinern, dass ein Einrasten des Bauelements praktisch unmöglich ist.

FIG.3D

## Feldeffektgesteuertes, bipolares Leistungshalbleiter-Bauelement sowie Verfahren zu seiner Herstellung

### Technisches Gebiet

Die Erfindung bezieht sich auf das Gebiet der Leistungshalbleiter-Bauelemente. Sie betrifft insbesondere ein feldeffektgesteuertes, bipolares Leistungshalbleiter-Bauelement, umfassend
- in einem Substrat zwischen einer Anode und einer Kathode eine p-Emitterschicht, eine n-Basisschicht, eine p-Basisschicht und eine n-Emitterschicht, wobei
-- die p-Basisschicht lateral in eine Mehrzahl von einzelnen p-Bereichen unterteilt ist, welche durch Zwischenräume voneinander getrennt sind;
-- in diesen Zwischenräumen die n-Basisschicht an die Oberfläche des Substrats tritt; und
-- in jedem der p-Bereiche die n-Emitterschicht in Form von einzelnen n-Bereichen eingebettet ist, derart, dass die p-Basisschicht an den Seiten der p-Bereiche und zwischen den n-Bereichen jedes p-Bereichs an die Oberfläche des Substrats tritt; und
- kathodenseitig eine Gate-Kathoden-Struktur mit abwechseind angeordneten Gateelektroden und Kathodenkontakten, wobei
-- über jedem der p-Bereiche ein Kathodenkontakt angeordnet ist, welcher mit allen n-Bereichen des zugehörigen p-Bereichs leitend verbunden ist, und diesen p-Bereich zwischen diesen n-Bereichen kontaktiert;
und
-- über jedem Zwischenraum zwischen benachbarten p-Bereichen eine durch eine Gateisolierung vom Substrat elektrisch isolierte Gateelektrode angeordnet ist, welche die an den Seiten der angrenzenden p-Bereiche an die Oberfläche tretende p-Basisschicht überdeckt.

Ein solches Bauelement ist z.B. aus dem Artikel von B.J. Baliga et al., IEEE Int. Electron Dev. Meet. Techn. Dig., S. 264-267 (1982), bekannt.

Die Erfindung betrifft weiterhin ein Verfahren zur Herstellung eines solchen Bauelements, bei welchem Verfahren zunächst das Substrat mit den verschiedenen Schichten versehen und kathodenseitig mit der Gateisolierung ganzflächig abgedeckt wird.

### Stand der Technik

Die Leistungselektronik als Zwischenglied zwischen Erzeuger und Verbraucher elektrischer Energie benötig mit einfachen Mitteln steuerbare Leistungsschalter.

Hierfür standen bisher Bauelemente wie GTOs oder Power-BJTs zur Verfügung, deren Ansteuerung allerdings sehr aufwendig ist. So werden beispielsweise beim GTO zum Abschalten hohe Gateströme benötig, die von der Ansteuerschaltung zur Verfügung gestellt werden müssen.

Die gewünschte Vereinfachung der Ansteuerschaltung kann im Prinzip durch Bauelemente mit isolierter Steuerelektrode erreicht werden, wie sie beispielsweise beim Leistungs-MOSFET vorliegt.

Der Nachteil der herkömmlichen Bauelemente mit isolierter Steuerelektrode besteht jedoch in dem durch den unipolaren Stromtransport bedingten hohen Durchlasswiderstand.

Seit einiger Zeit ist nun eine neue Bauelementstruktur bekannt, welche die Vorteile von bipolaren und MOS-Leistungsbauelementen miteinander verbindet (siehe z.B. die eingangs zitierte Druckschrift von B.J. Baliga et al. oder den Artikel von J.P. Russel et al., IEEE Electron Dev. Lett., EDL-4, S. 63-65 (1983)).

Die Struktur eines solchen IGT (Insulated Gate Transistor) oder IGR oder COMFET entspricht bis auf das Draingebiet derjenigen von modernen Leistungs-MOSFETs: Den Platz der n-dotierten Drainzone nimmt hier eine $p^+$-dotierte p-Emitterschicht ein.

Die Löcheremission aus diesem Gebiet wird durch Elektronen hervorgerufen und gesteuert, die über einen MOS-Inversionskanal unterhalb der isolierten Gateelektrode fliessen. Die Prinzipien der leistungsarmen Ansteuerung und der Leitfähigkeitsmodulation sind auf diese Weise miteinander vereint.

Der IGT besitzt allerdings eine wesentliche Schwäche: Seine Struktur besteht aus einer p-n-p-n-Vierschichtfolge, sodass im Bauelement parasitäre Thyristorstrukturen vorhanden sind. Wie bereits beschrieben worden ist (S. Nachad et al., IEEE Trans. Electron Dev., ED-32, S. 594-598 (1985)), neigt der IGT aus diesem Grund unter gewissen kritischen Bedingungen zum Einrasten ("latch-up") des Anodenstromes. Der Stromfluss entzieht sich in dieser Situation der Kontrolle durch das Gate, und das Bauelement kann in kurzer Zeit thermisch zerstört werden.

Es gilt daher, diesen Zerstörungsprozess zu verhindern, indem die IGT-Struktur gezielt dahingehend optimiert wird. Es zeigt sich dabei, dass es ein wesentliches Kriterium bei dieser Optimierung ist, den Bahnwiderstand in den p-Bereichen unterhalb der n-Bereiche zu minimieren.

So ist z.B. in dem Artikel von B.J. Baliga et al.,

IEEE Electron Dev. Lett., EDL-5, S. 323-325 (1984) vorgeschlagen worden, zwischen den n-Bereichen jedes p-Bereichs eine zusätzliche $p^+$-Zone vorzusehen, um den kritischen Bahnwiderstand zu verringern.

bwohl die Stromstärke, bei der das Bauelement einrastet, durch diese Massnahme erheblich vergrössert wird, ist gleichwohl die Gefahr des Einrastens nicht vollständig gebannt.

Darstellung der Erfindung

Aufgabe der vorliegenden Erfindung ist es nun, einen IGT in der Struktur so zu verändern, dass mit oder ohne zusätzliche $p^+$-Zone die Einraststromstärke soweit erhöht wird, dass das Bauelement weitgehend immun gegen das Einrasten ist.

Die Aufgabe wird bei einem Bauelement der eingangs genannten Art dadurch gelöst, dass die leitende Verbindung zwischen jedem Kathodenkontakt und den zugehörigen n-Bereichen über eine Leitschicht hergestellt wird, welche auf der Oberfläche des Substrats zwischen dem Kathodenkontakt und den zugehörigen n-Bereichen verläuft.

Ansatzpunkt der Erfindung ist ebenfalls die Minimierung des Bahnwiderstandes unterhalb der n-Bereiche. Es wird dabei angestrebt, den Bahnwiderstand durch eine Verkürzung der n-Be reiche zu reduzieren. Die kleinste realisierbare Ausdehnung der n-Bereich wird durch die verwendete Technologie diktiert.

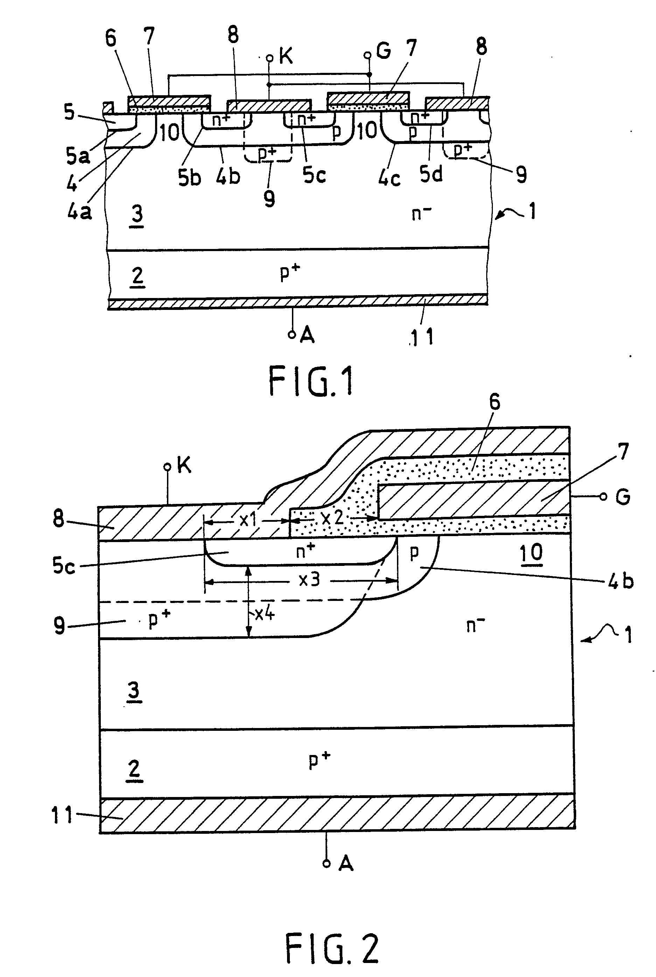

Die Länge (x3 in Fig. 2.) der n-Bereiche muss einerseits hinreichend gross sein, um die n-Bereiche und die p-Bereiche sicher kurzschliessen zu können. Andererseits muss aufgrund der Justierungenauigkeit ebenfalls ein Mindestabstand zwischen dem Kontaktloch für den Kathodenkontakt und der Gateelektrode gewahrt bleiben.

Für die bisher bekannte IGT-Struktur, bei der die n-Bereiche weit unter den Kathodenkontakt reichen, liegt die kleinste erreichbare Länge deutlich über 2 Mikrometer.

Der Kern der Erfindung besteht nun darin, den Kurzschluss der n-Bereich nicht länger durch eine grosse Ueberlappung mit dem Kathodenkontakt sicherzustellen, sondern auf der Oberfläche des Substrats eine spezielle Leitschicht vorzusehen, die diesen Kurzschluss bewirkt. Auf diese Weise kann die Länge der n-Bereiche, unabhängig vom vorher erwähnten Mindestabstand, stark reduziert werden.

Gemäss einem ersten bevorzugten Ausführungsbeispiel besteht diese Leitschicht aus einem Metallsilizid, wobei das Metall aus der Reihe Titan, Wolfram, Tantal und Kobalt ausgewählt ist. Mit derartigen Metallsilizid-Leitschichten wird bei einer relativ hohen Leitfähigkeit ein guter Kontakt, eine hohe Stabilität sowie eine gute Auflösung bei der Strukturierung erreicht.

Gemäss einem weiteren bevorzugten Ausführungsbeispiel bestehen die Gatelektroden aus Poly-Silizium und sind auf ihrer Oberseite mit einer gleichartigen Metallsilizid-Leitschicht versehen. Hierdurch kann der Widerstand der Gateanordnung gegenüber den bisherigen reinen Poly-Si-Schichten um nahezu eine Grössenordnung verkleinert werden, wodurch sich die dynamischen Eigenschaften des Bauelements nachhaltig verbessern.

Das erfindungsgemässe Verfahren ist durch die folgenden Schritte gekennzeichnet:
- Die Gateisolierung wird bis auf die Bereiche unterhalb der Gateelektroden und die Randbereiche um die Gateelektroden abgetragen;
- auf die freiliegende Oberfläche des Substrats wird die Leitschicht aufgebracht;
- die n-Bereiche und die Gateelektroden werden wieder mit der Gateisolierung abgedeckt; und
- anschliessend werden die Kathodenkontakte aufgebracht.

Gemäss einem bevorzugten Ausführungsbeispiel für das erfindungsgemässe Verfahren werden Gateelektroden aus Poly-Silizium verwendet, die gleichfalls mit einer Leitschicht versehen werden, wobei zum Aufbringen der Leitschichten zunächst ganzflächig ein Metall aus der Reihe Titan, Wolfram, Tantal und Kobalt abgeschieden und anschliessend in einem Temperprozess das entsprechende Metallsilizid gebildet wird.

Weitere Ausführungsbeispiele der Erfindung ergeben sich aus den Unteransprüchen.

Kurze Beschreibung der Zeichnung

Die Erfindung soll nachfolgend anhand von Ausführungsbeispielen im Zusammenhang mit der Zeichnung näher erläutert werden. Es zeigen:

Fig.1 den Querschnitt durch eine IGT-Struktur (ausschnittsweise) nach dem Stand der Technik;

fig.2 einen vergrösserten Teilbereich einer mit Fig. 1 vergleichbaren Struktur; und

Fig.3A-D verschiedene Schritte bei der Herstellung eines IGT gemäss einem Ausführungsbeispiel der Erfindung.

Wege zur Ausführung der Erfindung

In der Fig. 1 ist ausschnittsweise die Struktur eines IGT nach dem Stand der Technik dargestellt, wie sie aus den eingangs genannten Artikeln von B.J. Baliga et al. oder J.P. Russel et al. bekannt ist.

Bei dieser herkömmlichen Struktur sind in einem Substrat 1 zwischen einer Anode A und einer Kathode K unterschiedlich dotierte Schichten und Bereiche in einer Schichtenfolge angeordnet.

Die Schichtenfolge umfasst eine $p^+$-dotierte p-Emitterschicht 2, eine $n^-$-dotierte n-Basisschicht 3, eine p-dotierte p-Basisschicht 4 und $n^+$-dotierte n-Emitterschicht 5.

Die p-Basisschicht 4 ist in einzelne p-Bereiche 4a,...c unterteilt, die durch Zwischenräume 10 voneinander getrennt sind. In diesen Zwischenräumen 10 tritt die darunterliegende n-Basisschicht 3 an die kathodenseitige Oberfläche des Substrats 1.

In jedem der p-Bereiche 4a,...c ist die n-Emitterschicht 5 in Form von einzelnen n-Bereichen 5a,...,e eingebettet. Die p-Basisschicht 4 tritt dabei an den Seiten der p-Bereiche 4a,...c und zwischen den zugehörigen n-Bereichen ebenfalls an die kathodenseitige Oberfläche des Substrats 1.

Die kathodenseitige Gate-Kathoden-Struktur umfasst abwechselnd angeordnete Gateelektroden 7 und Kathodenkontakte 8. Ueber je dem der p-Bereiche 4a,...c ist jeweils ein Kathodenkontakt 8 angeordnet, der alle n-Bereiche des jeweiligen p-Bereichs und auch den zwischen diesen n-Bereichen an die Oberfläche tretenden p-Bereich direkt kontaktiert.

Ueber jedem Zwischenraum 10 ist seinerseits eine Gateelektrode 7 auf die Substratoberfläche aufgebracht und von dem Substrat 1 durch eine geeignete Gateisolierung 6 z.B. aus $SiO_2$ elektrisch getrennt. Die Gateelektrode 7 überdeckt dabei nicht nur den entsprechenden Zwischenraum 10, sondern auch die Gebiete der angrenzenden p-Bereiche, in denen die p-Basisschicht 4 an die Substratoberfläche tritt.

Die Gateelektroden 7 sind mit dem Gate G des Bauelements verbunden. Anodenseitig ist auf die p-Emitterschicht 2 ein ganzflächiger Anodenkontakt 11 aufgebracht und an die Anode A angeschlossen.

Zusätzlich kann zwischen den n-Bereichen jedes p-Bereichs noch eine $p^+$-Zone 9 vorgesehen sein, welche durch die p-Basisschicht 4 hindurch bis in die n-Basisschicht 3 reicht, und dazu dient, die Neigung des Bauelements zum "latch-up" zu verringern.

Auf die Funktionsweise des IGT braucht hier nicht näher eingegangen zu werden, da diese bereits ausführlich in den zitierten Druckschriften beschrieben worden ist.

Die Nachteile der bekannten IGT-Struktur können an dem in Fig. 2 wiedergegebenen Ausschnitt aus einer einzelnen Zelle des IGT deutlich gemacht werden: Wie bereits eingangs erwähnt, ist für das Einrasten der parasitären Thyristorstruktur im IGT massgeblich der Bahnwiderstand im p-Bereich (4b) unterhalb des n-Bereichs (5c) verantwortlich, je kleiner dieser Bahnwiderstand ist, desto geringer ist auch die Neigung des Bauelements zum Einrasten.

Der Bahnwiderstand kann entweder durch eine Verkleinerung des spezifischen Widerstands im Bahngebiet (z.B. durch die $p^+$-Zone 9), oder durch eine Verkürzung der Bahn verringert werden.

Die vorliegende Erfindung strebt nun an, die Länge der Bahn zu verkürzen. Die Bahnlänge wird dabei massgeblich von der Länge x3 des n-Bereichs 5c bestimmt.

Die Länge x3 des n-Bereichs ihrerseits wird durch die verwendete Technologie festgelegt: Bei einem IGT nach dem Stand der Technik muss x3 hinreichend gross sein, um den n-Bereich und die p-Basisschicht sicher kurzschliessen zu können. Dies bedingt eine Ueberlappung des n-Bereichs mit dem Kathodenkontakt auf der Länge x1 (Fig. 2).

Andererseits muss aufgrund von unvermeidlichen Justierungenauigkeiten auch ein Mindestabstand (Länge x2 in Fig. 2) zwischen dem Kontaktloch des Kathodenkontakts 8 und der benachbarten Gateelektrode 7 gewahrt bleiben. Aus diesen Vorbedingungen folgt bei den bekannten IGT eine Länge x2 von deutlich über 2 Mikrometern, die nicht unterschritten werden kann.

Während die Länge x2 nicht ohne grösseren Aufwand reduziert werden kann, lässt sich die Länge x3 drastisch herabsetzen, wenn gemäss der Erfindung der Zusammenhang zwischen den Längen x1 und x3 aufgehoben wird, d.h. wenn die n-Bereiche ohne Ueberlappung kurzgeschlossen werden.

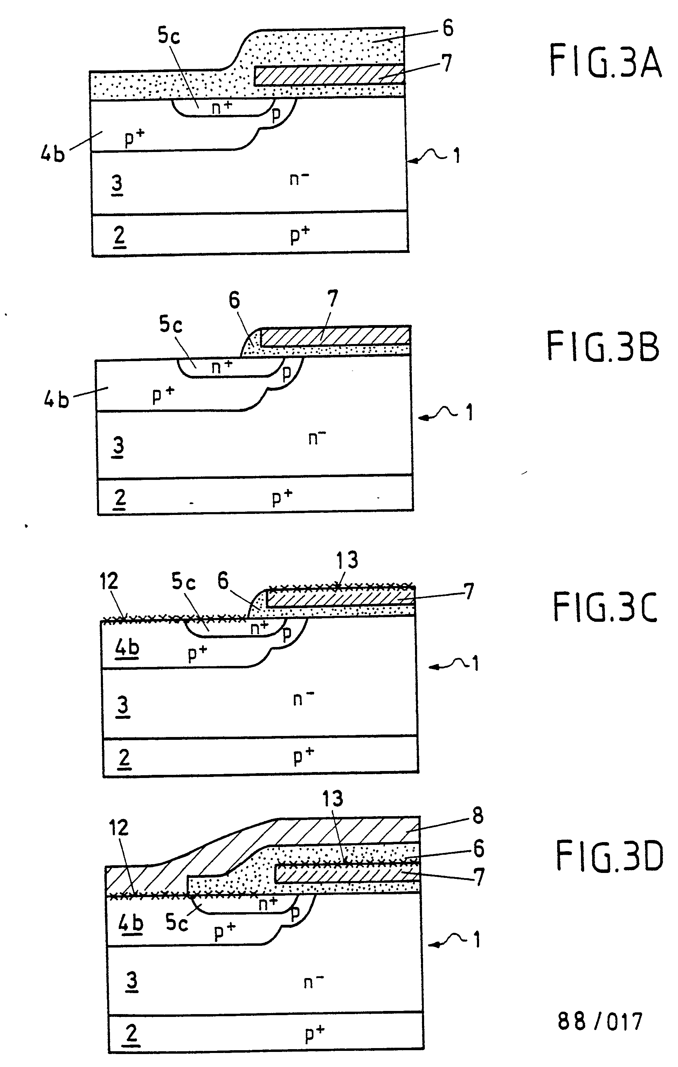

Die notwendige elektrische Verbindung zwischen dem n-Bereich 5c und dem zugehörigen Kathodenkontakt 8 wird in deisem Fall durch eine spezielle Leitschicht 12 (Fig. 3D) hergestellt, welche auf der Substratoberfläche vom n-Bereich 5c bis zum Kathodenkontakt 8 verläuft.

Vorzugsweise besteht diese Leitschicht 12 aus einer dünnen Metallsilizid-Schicht, wobei ein Metall aus der Reihe Titan, Wolfram, Tantal und Kobalt verwendet wird.

Ein solches Metallsilizid-Kontaktierungssystem hat sich bereits bei der Höchstintegration bewährt (siehe z.B. F.-S.J. Lai et al., IEEE Trans. Electron Dev., Ed-33, S. 345-353 (1986)), ist mit der Halbleitertechnologie kompatibel und zeichnet sich durch eine hohe Beständigkeit aus.

Der Kurzschluss des n-Bereichs 5c mit dem p-Bereich 4b wird auf diese Weise durch die unter dem Kathodenkontakt 8 und der Gateisolierung 6 vergrabene Leitschicht 12 bewerkstelligt. Dies erlaubt, die Länge x3 so klein wie technologisch möglich auszulegen, und damit zumindest die mit der Ueberlappung verbundene Länge x1 einzusparen. Die n-Bereiche sind dann vollständig von der Gateisolierung 6 überdeckt.

Weitere Vorteile ergeben sich, wenn bei einer Gateelektrode 7 aus Poly-Silizium zusätzlich auf der Elektrodenoberfläche eine zweite, gleichartige Leitschicht 13 (Fig. 3D) aufgebracht wird. Hierdurch kann der vergleichsweise hohe Gatewiderstand erheblich reduziert und damit das dynamische Verhalten des Bauelements erheblich verbessert werden.

Darüberhinaus können beide Leitschichten 12 und 13 leicht in einem einzigen Prozess erzeugt werden.

Verschiedene Schritte einer bevorzugten Ausführungsform des erfindungsgemässen Verfahrens sind in Fig. 3A-D wiedergegeben.

Es wird dabei von einem Stadium ausgegangen, in dem die Dotierung innerhalb des Substrats 1 bereits vorhanden ist, die Gateelektroden 7 (aus Poly-Si) entsprechend strukturiert sind, und eine Gateisolierung 6 (aus der Gasphase nach dem LPCVD-Verfahren abgeschiedenes SiO$_2$) die ganze Oberfläche abdeckt (Fig. 3A).

Abweichend vom Stand der Technik wird nun die Gateisolierung 6 anisotrop und ganzflächig geätzt; hierbei bietet sich zum Beispiel das reaktive Ionenätzen (RIE) an. Wegen der Dickeninhomogenitäten an der Kante der Gateelektrode 7 bleibt dort ein Randbereich der Gateisolierung stehen; ebenso bleibt die Gateisolierung unter den Gateelektroden 7 erhalten (Fig. 3B).

Ueber der Struktur wird nun ganzflächig ein Metall aufgedampft oder abgeschieden, welches mit Silizium ein hochtemperaturstabiles Metallsilizid bildet (siehe auch T.P. Chow et al., IEEE Trans. Electron Dev., ED-30, S. 1480-1497 (1983)). Geeignete Metalle sind beispielsweise Titan, Wolfram, Tantal und Kobalt.

Nach der Bedampfung oder Deposition des Metalls erfordert die Formierung des Silizids einen Temperprozess. Die Temperatur kann dabei so gewählt werden, dass die Silizidbildung auf dem Substrat und der Poly-Si-Gateelektrode stattfindet, nicht jedoch auf den Randbereichen der SiO$_2$-Gateisolierung an der Gateelektrodenkante. Das dort verbleibende, unreagierte Metall kann dann in einem nasschemischen Aetzprozess entfernt werden. Damit liegt die in Fig. 3C dargestellte Struktur vor, wobei die Leitschichten 12,13 durch Kreuze angedeutet sind.

Um die höchstmögliche Leitfähigkeit der Silizidschicht zu erzielen, ist ein weiterer Temperprozess, diesmal bei höheren Temperaturen, angezeigt.

Die Struktur kann anschliessend in der üblichen Weise weiterbehandelt werden: Nach der Deposition einer isolierenden SiO$_2$-Schicht wird ein Kontaktloch durch diese Schicht geöffnet, und schliesslich die Kathodenmetallisierung (Kathodenkontakt 8) aufgebracht (Fig. 3D).

Insgesamt werden mit der Erfindung Verbesserungen erzielt, die bei einem Vergleich der Fig. 2 und 3D deutlich werden:

- Der Kurzschluss der n-Bereiche mit der p-Emitterschicht wird durch die vergrabene, hochleitende Leitschicht 12 bewerkstelligt. Dies erlaubt, die Länge x3 der n-Bereiche so klein wie technologisch möglich zu wählen und damit eine hohe Sicherheit gegen Einrasten zu erzielen.

- Wegen der hohen Leitfähigkeit der Leitschicht 12 kann auf relativ tiefe n-Bereiche verzichtet werden. Dadurch kann die vertikale Ausdehnung der p-Emitterschicht 4 unterhalb der n-Bereiche (Länge x4 in Fig. 2) vergrössert werden. Dies kommt ebenfalls der Reduzierung des Bahnwiderstandes zugute.

- Mit dem n-Bereich kann ebenfalls eine Poly-Si-Gateelektrode, die üblicherweise nicht über eine besonders hohe Leitfähigkeit verfügt, eine Leitschicht 13 erhalten. Der Widerstand des Gates kann so um nahezu eine Grössenordnung verkleinert werden. Die dynamischen Eigenschaften des Bauelements werden hierdurch nachhaltig verbessert.

- Die Erfindung lässt sich sowohl auf IGTs ohne p$^+$-Zone als auch IGTs mit p$^+$-Zone anwenden.

Schliesslich sei noch ausdrücklich darauf hingewiesen, dass sich die Erfindung nicht nur auf Bauelemente mit der angegebenen Schichtfolge bezieht, sondern genauso auf Bauelemente mit einer komplementären Schichtfolge angewendet werden kann, wie sie z.B. aus dem Artikel von J.P. Russel et al., IEEE Electron Dev. Lett., EDL-5, S. 437-439 (1984) bekannt sind.

In diesem Fall werden die p-Emitterschicht, die n-Basisschicht, die p-Basisschicht, die n-Emitterschicht, die p-Bereiche und die n-Bereiche durch eine entsprechende n-Emitterschicht, p-Basisschicht, n-Basisschicht, p-Emitterschicht, n-Bereiche und p-Bereiche ersetzt.

## Ansprüche

1. Feldeffektgesteuertes, bipolares Leistungshalbleiter-Bauelement, umfassend

(a) in einem Substrat (1) zwischen einer Anode (A) und einer Kathode (K) eine p-Emitterschicht (2), eine n-Basisschicht (3), eine p-Basisschicht (4), und eine n-Emitterschicht (5), wobei

(aa) die p-Basisschicht (4) lateral in eine Mehrzahl von einzelnen p-Bereichen (4a,..,c) unterteilt ist, welche durch Zwischenräume (10) voneinander getrennt sind;

(bb) in diesen Zwischenräumen (10) die n-Basisschicht (3) an die Oberfläche des Substrats (1) tritt; und

(cc) in jedem der p-Bereiche (4a,..,c) die n-Emitterschicht (5) in Form von einzelnen n-Bereichen (5a,..,e) eingebettet ist, derart, dass die p-Basisschicht (4) an den Seiten der p-Bereiche (4a,..c) und zwischen den n-Bereichen jedes p-Bereichs an die Oberfläche des Substrats (1) tritt; und

(b) kathodenseitig eine Gate-Kathoden-Struktur mit abwechselnd angeordneten Gateelektroden (7) und Kathodenkontakten (8), wobei

(aa) über jedem der p-Bereiche (4a,..,c) ein Kathodenkontakt (8) angeordnet ist, welcher mit allen n-Bereichen des zugehörigen p-Bereichs leitend verbunden ist, und diesen p-Bereich zwischen diesen n-Bereichen kontaktiert; und

(bb) über jedem Zwischenraum (10) zwischen benachbarten p-Bereichen eine durch eine Gateisolierung (6) vom Substrat (1) elektrisch isolierte Gateelektrode (7) angeordnet ist, welche die an den Seiten der angrenzenden p-Bereiche an die Oberfläche tretende p-Basisschicht (4) überdeckt; dadurch gekennzeichnet, dass

(c) die leitende Verbindung zwischen jedem Kathodenkontakt (8) und den zugehörigen n-Bereichen über eine Leitschicht (12) hergestellt wird, welche auf der Oberfläche des Substrats (1) zwischen dem Kathodenkontakt (8) und den zugehörigen n-Bereichen verläuft.

2. Bauelement nach Anspruch 1, dadurch gekennzeichnet, dass zwischen den n-Bereichen jedes p-Bereichs jeweils eine $p^+$-Zone (9) angeordnet ist, welche von der Oberfläche des Substrats (1) durch die p-Basisschicht (4) hindurch bis in die n-Basisschicht (3) hineinreicht.

3. Bauelement nach einem der Ansprüche 1 oder 2, dadurch gekennzeichnet, dass die Leitschicht (12) aus einem Metallsilizid besteht.

4. Bauelement nach Anspruch 3, dadurch gekennzeichnet, dass als Metall der Leitschicht (12) ein metall aus der Reihe Titan, Wolfram, Tantal und Kobalt verwendet wird.

5. Bauelement nach Anspruch 4, dadurch gekennzeichnet, dass die n-Bereiche (5a,..,e) von der Gateisolierung (6) vollständig überdeckt sind.

6. Bauelement nach Anspruch 5, dadurch gekennzeichnet, dass die Gateelektroden (7) aus Poly-Silizium bestehen und auf ihrer Oberseite mit einer gleichartigen Leitschicht (13) versehen sind.

7. Verfahren zur Herstellung eines Bauelements nach Anspruch 1, bei welchem Verfahren zunächst das Substrat (1) mit den verschiedenen Schichten (2,3,4,5) und Bereichen (4a,..,c; 5a,..,e) hergestellt, mit den Gateelektroden (7) versehen, und kathodenseitig mit der Gateisolierung (6) ganzflächig abgedeckt wird; dadurch gekennzeichnet, dass

(a) die Gateisolierung (6) bis auf die Bereiche unterhalb der Gateelektoden (7) und die Randbereiche um die Gateelektroden (7) abgetragen wird;

(b) auf die freiliegende Oberfläche des Substrats (1) die Leitschicht (12) aufgebracht wird;

(c) die n-Bereiche (5a,..,e) und die Gateelektroden (7) wieder mit der Gateisolierung (6) abgedeckt werden; und

(d) anschliessend die Kathodenkontakte (8) aufgebracht werden.

8. Verfahren nach Anspruch 7, dadurch gekennzeichnet, dass Gateelektroden (7) aus Poly-Silizium verwendet werden, und beim Aufbringen der Leitschicht (12) auf das Substrat (1) gleichzeitig auch die Gateelektroden (7) mit einer Leitschicht (13) versehen werden.

9. Verfahren nach Anspruch 8, dadurch gekennzeichnet, dass zum Aufbringen der Leitschichten (12,13) zunächst ganzflächig ein Metall aus der Reihe Titan, Wolfram, Tantal und Kobalt abgeschieden, und anschliessend in einem Temperprozess das entsprechende Metallsilizid gebildet wird.

10. Verfahren nach Anspruch 9, dadurch gekennzeichnet, dass

(a) als Gateisolierung (6) SiO2 verwendet wird;

(b) der Temperprozess zunächst bei einer Temperatur vorgenommen wird, bei welcher die Silizidbildung auf der Oberfläche des Substrats (1) und der Gateelektroden (7), nicht jedoch auf der Oberfläche der Gateisolierung stattfindet;

(c) dann das Metall von der Oberfläche der Gateisolierung (6) entfernt wird; und

(d) anschliessend der Temperprozess bei höheren Temperaturen fortgesetzt wird.

## FIG.1

## FIG.2

FIG.3A

FIG.3B

FIG.3C

FIG.3D

88 / 017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 466 176 (V.A.K. TEMPLE)<br>* Spalte 2, Zeile 18 - Spalte 3, Zeile 11; Spalte 11, Zeilen 46-66; Spalte 12, Zeilen 20-32; Figuren 4,6 * | 1-3 | H 01 L 29/72<br>H 01 L 29/54<br>H 01 L 29/62<br>H 01 L 21/285<br>H 01 L 21/60 |
| Y | --- | 4-10 | |
| Y | IEEE TRANSACTIONS ON ELECTRON DEVICES, Band ED-32, Nr. 2, Februar 1985, Seiten 203-209, IEEE, New York, US; Y. TAUR et al.: "A self-aligned 1-mum-Channel CMOS technology with Retrograde n-Well and Thin Epitaxy"<br>* Seite 204, rechte Spalte, Zeile 13 - Seite 205, linke Spalte, Zeile 2; Figuren 1i,1j * | 4-10 | |
| A | IDEM | 1 | |
| Y | --- <br>PATENT ABSTRACTS OF JAPAN, Band 10, Nr. 113 (E-399)[2170], 26. April 1986, Seite 124 E 399; & JP-A-60 249 370 (MITSUBISHI DENKI K.K.) 10-12-1985<br>* Zusammenfassung; Figuren 3,6 * | 5,6 | |
| A | IDEM | 1,2 | RECHERCHIERTE SACHGEBIETE (Int. Cl.4)<br><br>H 01 L |
| A | --- <br>INTERNATIONAL ELECTRON DEVICES MEETING, TECHNICAL DIGEST, San Fransisco, CA, 13.-15. Dezember 1982, Seiten 714-717, IEEE, New York, US; C.K. LAU et al.: "Titanium disilicide self-aligned source/drain + gate technology"<br>* Seite 714, Abschnitt "Device fabrication"; Figur 1 *<br>---     -/- | 4,6-10 | |

Der vorliegende Recherchenbericht wurde für alle Patentansprüche erstellt

| Recherchenort | Abschlußdatum der Recherche | Prüfer |
|---|---|---|
| DEN HAAG | 30-05-1989 | MORVAN D.L.D. |

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | IEEE ELECTRON DEVICE LETTERS, Band EDL-5, Nr. 8, August 1984, Seiten 323-325, IEEE, New York, US; B.J. BALIGA et al.: "Suppressing latchup in insulated gate transistors" * Figuren 2,3 * | 1,2 | |
| A | EP-A-0 103 934 (PHILIPS ELECTRONIC & ASS. INDUSTRIES LTD et al.) * Seite 7, Zeilen 10-12,19-23; Seite 9, Zeile 15 - Seite 10, Zeile 15; Figur 2 * | 1,3,5-8 | |
| | | | RECHERCHIERTE SACHGEBIETE (Int. Cl.4) |

Der vorliegende Recherchenbericht wurde für alle Patentansprüche erstellt

| Recherchenort | Abschlußdatum der Recherche | Prüfer |
|---|---|---|
| DEN HAAG | 30-05-1989 | MORVAN D.L.D. |